Europäisches Patentamt

European Patent Office

Office européen des brevets

(19)

(11) Veröffentlichungsnummer: **0 027 628**

**A1**

(12) # EUROPÄISCHE PATENTANMELDUNG

(21) Anmeldenummer: 80106236.5

(22) Anmeldetag: 14.10.80

(51) Int. Cl.³: **G 21 K 5/04**
//H01J37/317, H01L21/265

(30) Priorität: 17.10.79 DE 2942045

(46) Veröffentlichungstag der Anmeldung:
29.04.81 Patentblatt 81/17

(84) Benannte Vertragsstaaten:
DE FR GB IT

(71) Anmelder: SIEMENS AKTIENGESELLSCHAFT Berlin
und München
Postfach 22 02 61
D-8000 München 22(DE)

(72) Erfinder: Glawischnig, Hans, Dr.
Bacherstrasse 39
D-8000 München 90(DE)

(72) Erfinder: Hoerschelmann, Konstantin, Dipl.-Phys.
Schüleinplatz 4
D-8000 München 80(DE)

(54) Verfahren zur gleichmässigen Ausleuchtung von Flächen mittels eines Strahles.

(57) Der Erfindung liegt die Aufgabe zugrunde, ein Verfahren zur Ausleuchtung von Flächen mittels eines Strahls von annähernd gauß' scher Verteilung bezüglich seiner Intensität anzugeben, bei dem der Strahl relativ zur auszuleuchtenden Fläche periodische Ablenkungen in zwei zueinander senkrechten Richtungen erfährt, wodurch die auszuleuchtende Fläche vom Strahl zeilenweise abgerastert und möglichst homogen ausgeleuchtet wird.

Erfindungsgemäß wird eine homogene Flächenausleuchtung dadurch erreicht, daß die periodischen Ablenkungen zwischen dem Strahl und der auszuleuchtenden Fläche in einem festen Verhältnis zueinander stehen, daß das 1,5 fache der Standardabweichung des Strahls größer ist als der Abstand zweier benachbarter Schreibspuren.

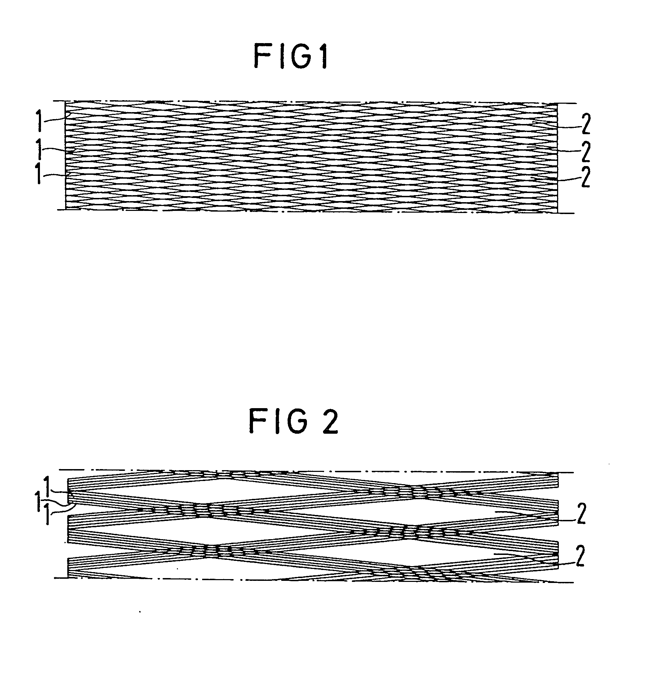

Anwendung bei Halbleiterbauelementen und integrierten Schaltungen (Fig. 1).

FIG 1

SIEMENS AKTIENGESELLSCHAFT          Unser Zeichen

Berlin und München                  VPA  79 P 1 1 7 6  EUR

Verfahren zur gleichmäßigen Ausleuchtung
von Flächen mittels eines Strahles

Die Erfindung betrifft ein Verfahren zur Ausleuchtung von
Flächen mittels eines Strahls von annähernd gauß'scher
Verteilung bezüglich seiner Intensität von der Strahlmittelachse radial zum Rand hin, bei dem der Strahl
relativ zu der auszuleuchtenden Fläche periodische Ablenkungen in zwei annähernd senkrecht zueinander verlaufenden Richtungen erfährt, die so beschaffen sind, daß
die auszuleuchtende Fläche vom Strahl zeilenweise abgerastert wird.

Die gleichmäßige Ausleuchtung von Flächen mittels eines
Strahls ist in verschiedenen Gebieten von Physik und
Technik ein bedeutendes Problem. In vielen Fällen rastert man die auszuleuchtende Fläche mittels eines gebündelten Strahls zeilenförmig ab, wie z.B. bei der Aufzeichnung eines Fernsehbildes. Der Strahl erfährt dabei
periodische Ablenkungen in zwei annähernd senkrecht zueinander verlaufenden Richtungen. Maßgeblich für eine

Kus 1 Kg/ 15.10.1979

gleichmäßige Ausleuchtung einer Fläche ist außer der Strahlbewegung auch die Intensitätsverteilung des Strahls in Abhängigkeit vom Strahldurchmesser. Die Intensitätsverteilung eines Strahls über den Durchmesser ist jedoch in sehr vielen Fällen von vornherein eine annähernd gauß'sche Verteilung oder es läßt sich durch Variation gewisser Parameter eine annähernd gauß'sche Intensitätsverteilung erreichen.

Versuche ergaben, daß das häufige Abrastern eines Bildes mit einem Strahl durchaus nicht unter allen Bedingungen zu einem gleichmäßigen Ausleuchten der Gesamtfläche führt. Unter gewissen Bedingungen werden hingegen gewisse Teile einer auszuleuchtenden Fläche vom darüberstreichenden Strahl bevorzugt getroffen, während andere Flächenteile auch bei mehrmaligem Überstreichen der auszuleuchtenden Fläche vom Strahl praktisch nicht erreicht werden. Eine Steigerung der Häufigkeit, mit der unter solchen Umständen ein Strahl eine Fläche überstreicht, bewirkt keineswegs immer eine gleichmäßigere Ausleuchtung der zu beleuchtenden Fläche, sondern verstärkt gelegentlich die Ungleichmäßigkeit der Ausleuchtung. Diese Verhältnisse sind für Ionenstrahlen anhand von sogenannten Lissajous-Figuren deutlich darstellbar (vergl. Fig. 2).

Aufgabe der vorliegenden Erfindung ist es daher, ein Verfahren zur Ausleuchtung von Flächen mittels eines Strahls von annähernd gauß'scher Verteilung bezüglich seiner Intensität von der Strahlmittelachse radial zum Rand hin, bei dem der Strahl relativ zur auszuleuchtenden Fläche periodische Ablenkungen in zwei annähernd senkrecht zueinander verlaufenden Richtungen erfährt, die so beschaffen sind, daß die auszuleuchtende Fläche vom Strahl zeilenweise abgerastert wird, anzugeben, das eine möglichst homogene Ausleuchtung von Flächen gewährleistet.

Diese Aufgabe wird dadurch gelöst, daß die periodischen Ablenkungen zwischen dem Strahl und der auszuleuchtenden Fläche so in einem festen Verhältnis zueinander stehen, daß das 1,5fache der Standardabweichung des Strahls größer ist als der Abstand zweier benachbarter Schreibspuren.

Mit dieser Bedingung läßt sich in vorteilhafter Weise z.B. mittels eines Ionenstrahls ein vorgegebenes Substrat möglichst homogen, d.h. mit einer Homogenität besser als 1%, bestrahlen, was zur Ionenimplantation in Halbleitersubstraten angewendet werden kann. Die Erfindung beschränkt sich aber nicht auf dieses Ausführungsbeispiel, sie ist vielmehr ebenfalls z.B. auf einen entsprechenden optischen Strahl oder auf einen entsprechenden Elektronenstrahl oder auf entsprechende Teilchenstrahlen anwendbar, wenn die periodischen Strahlablenkungen relativ zur beleuchtenden Fläche den kennzeichnenden Teil des Anspruchs 1 erfüllen.

Es ist vorteilhaft, daß die Frequenzen der periodischen Ablenkungen des Strahls phasenstarr gekoppelt sind. Unter einer phasenstarren Kopplung versteht man in diesem Zusammenhang die Tatsache, daß die beiden anliegenden Frequenzen der periodischen Ablenkungen des Strahls gegenüber der Fläche, über die gesamte Bestrahlungsdauer der Fläche keine Phasenverschiebung gegeneinander aufweisen. Mit dieser Maßnahme läßt sich bei sonst gleichen Bedingungen die Homogenität der Ausleuchtung von Flächen um den Faktor 2 verbessern.

0027628

Es ist auch erfinderisch, daß der Strahl aus einem geladenen Teilchenstrahl besteht.

In verschiedenen Gebieten der Physik und Technik werden Flächen mit geladenen Teilchenstrahlen abgerastert. Bei der Ionenimplantation von Halbleitersubstraten verwendet man hierzu Ionenstrahlen und zwar je nach gewünschter Dotierungsart des Halbleitersubstrats geeignete Ionenarten. Gerade zu Zwecken der Ionenimplantation ist es sehr wichtig, daß die gesamte Substratplatte homogen bestrahlt wird.
Diese Gleichmäßigkeit wird bei den verschiedenen Verfahren durch verschiedene Strahlablenkungen bewirkt.

Bei mechanischen Ablenkverfahren erfolgt die Ablenkung durch die Bewegung des Objekts in zwei Richtungen senkrecht zum Ionenstrahl.

Bei dem sogenannten Hybrid-Scan erfolgt die Strahlablenkung durch eine mechanische Ablenkung des Implantationsobjektes in einer Richtung, z.B. mittels einer bewegten Trommel, und einer gleichzeitigen elektrostatischen oder magnetischen Ablenkung des Ionenstrahls in einer anderen Richtung.

Schließlich sind Ionenstrahlimplantations-Vorrichtungen bekannt, bei denen der Ionenstrahl elektrostatisch oder magnetisch abgelenkt wird. Bei solchen Apparaten kann der Ionenstrahl bei bestimmten Einstellungen auf einige Zehntel mm Durchmesser fokussiert werden, wobei das Strahlprofil eine beliebige Teilchenverteilung aufweisen kann. Stellt man den Strahldurchmesser so ein, daß er die Größenordnung des Abstandes zweier benachbarter Schreibspuren erreicht, so lassen sich erhebliche wellenförmige Inhomogenitäten in der Konzentra-

0027628

tionsverteilung im dotierten Objekt feststellen. Je nach eingestellten Strahlbedingungen weisen diese wellenförmigen Inhomogenitäten teilweise sehr kleine Perioden auf.

Werden alle angeführten Methoden zur Ablenkung eines geladenen Teilchenstrahls, insbesondere relativ zur bestrahlten Fläche in der Weise durchgeführt, daß zugleich die Bedingungen des Anspruchs 1 und möglicherweise zusätzlich des Anspruchs 2 erfüllt werden, so läßt sich eine optimale Ausleuchtung der bestrahlten Fläche erreichen.

Es ist auch vorteilhaft, daß die periodische Strahlablenkung mittels zweier senkrecht zueinander gekreuzter Ablenkplattenpaare, an denen Abtastfrequenzen (Scanfrequenzen) anliegen, elektrisch erfolgt, sofern es sich um einen geladenen Teilchenstrahl handelt. Es ist selbstverständlich dafür zu sorgen, daß die Abtastfrequenzen (Scanfrequenzen) die Bedingung aus dem kennzeichnenden Teil von Anspruch 1 erfüllen, möglicherweise auch zusätzlich noch die Bedingungen des kennzeichnenden Teils von Anspruch 2 erfüllen. Die Erfüllung dieser Bedingung läßt sich in vorteilhafter Weise technisch leicht durch eine elektrische Ablenkung eines geladenen Teilchenstrahls durch Anlegen geeigneter elektrischer Ablenkfrequenzen an gekreuzten Plattenpaaren realisieren. Wie an Bild 1 noch erläutert wird, läßt sich mit diesen Bedingungen eine homogene Ausleuchtung einer Fläche mittels geladener Teilchenstrahlen erreichen.

Es ist auch erfinderisch, daß der Strahl ein Ionenstrahl ist, der von einem 1 MHz-Oszillator erzeugt wird und daß die eine der beiden Abtastfrequenzen (Scanfrequenzen) 500 Hz und die andere Abtastfrequenz (Scanfrequenz) 1234, 567 Hz beträgt. Für die Ionenimplantation von Halbleitersubstraten, insbesondere Siliciumsubstraten, hat sich ein derart erzeugter Ionenstrahl in Verbindung mit den angegebenen Abtastfrequenzen als besonders vorteilhaft für die Homogenität der hiermit implantierten Substrate erwiesen.

Nachfolgend wird die Erfindung anhand der Zeichnung und den Ausführungsbeispielen näher erläutert.

Es zeigen:

Fig. 1    einen Ausschnitt aus einer Lissajous-Figur, bei der das Verhältnis der eingestellten Abtastfrequenz 515 : 50 beträgt;

Fig. 2    eine Lissajous-Figur, bei der das Verhältnis der angelegten Abtastfrequenzen 517 : 50 beträgt;

Fig. 3    einen Kapazitätsverlauf als Maß für einen Schichtwiderstandsverlauf, gemessen längs des Durchmessers einer Silicium-Probescheibe, die mit implantierten Kapazitätsdioden versehen ist.

Fig. 1 zeigt einen Ausschnitt aus einer mittels Rechner und Plotter hergestellten Lissajous-Figur, wobei die Linien 1 die Linien darstellen, längs derer sich der Mittelstrahl an der Oberfläche eines zu implantierenden Substrats bewegt. Das Frequenzverhältnis der eingestellten Abtast-Frequenzen beträgt bei dieser Figur 515 : 50. Dieses günstige Frequenzverhältnis bewirkt relativ kleine rautenförmige Zwischenräume 2, die vom Mittelstrahl nicht unmittelbar überstrichen werden.

Fig. 2 stellt ebenfalls, wie in Fig. 1, einen Ausschnitt aus einer Lissajous-Figur mit gleichen Abmessungen wie Fig. 1 dar. Das Frequenzverhältnis der angelegten Abtastfrequenzen beträgt jedoch 517 : 50. Gegenüber Fig. 1 weist Fig. 2 wesentlich größere rautenförmige Zwischenräume 2 auf, die vom Ionenstrahl nicht überstrichen werden, während die Linien 1, die die Bewegung des Ionenstrahls auf dem zu implantierenden Halbleitersubstrat darstellen, in gewissen Bereichen stärker verdichtet sind.

Ein Vergleich von Fig. 1 und Fig. 2 zeigt auf den ersten Blick, daß die Ionenbestrahlung nach Fig. 1 eine erheblich bessere Gleichmäßigkeit über die Probenoberfläche aufweist, als die entsprechende Bestrahlung nach Fig. 2. Man erkennt, daß bereits geringe Veränderungen im Verhältnis der Abtastfrequenzen eine erhebliche Veränderung in der Homogenität der Oberflächenausleuchtung bei der Ionen-Implantation bewirken. Bei der Einstellung des Ionenstrahls nach Fig. 1 wurde außer der Forderung des Anspruch 1 auch die Forderung des Anspruchs 2, d.h. die phasenstarre Kopplung der Abtastfrequenzen eingehalten. Bei sonst gleichen physikalischen Bedingungen bewirkt die phasenstarre Kopplung eine Verbesserung um den Faktor 2 hinsichtlich der Homogenität der implantierten Oberflächenkonzentration.

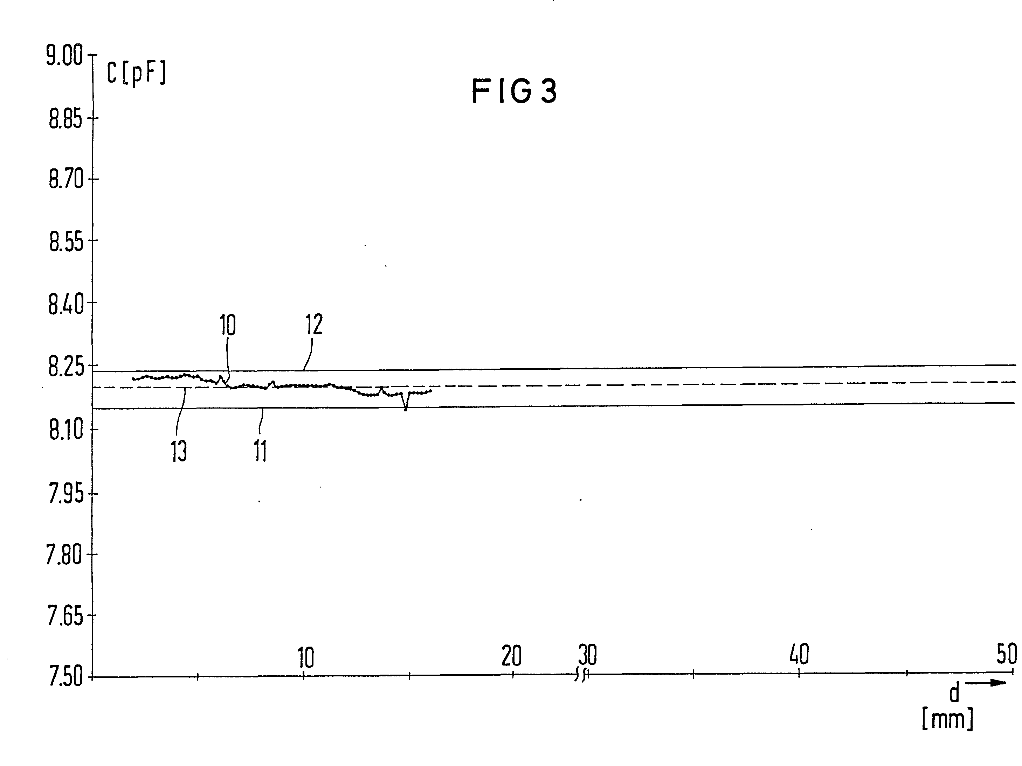

Fig. 3 ist ein Ausschnitt aus einer Kapazitätskurve, die mittels Kapazitätsdioden bei 1 V Spannung über den Durchmesser d einer Silicium-Testscheibe von d = 50 mm gemessen wurde. Dabei wurde die mittels einer Kapazitätsdiode ermittelte Kapazität in pF gegen den radialen Abstand von einem äußeren Scheibenrandpunkt aufgetragen. Die gemessene Kapazität ist proportional zur implantierten Dotierung in der Halbleiterscheibe, so daß die

Kapazitätskurve 10 zugleich ein Maß für die implantierte Dotierung wiedergibt. Die strichlierte Linie 13 gibt denjenigen Kapazitätswert an, der dem Mittelwert der Scheibendotierung entspricht. Die Linie 11 bezeichnet denjenigen Kapazitätswert, der sich aus einer Dotierung $\bar{N} - 2\sigma$ ergibt, d.h. aus dem statistischen Mittelwert der Dotierung minus zwei mal der Standardabweichung $\sigma$. Entsprechend bezeichnet die Linie 12 diejenige Kapazität, die der Dotierung $\bar{N} + 2\sigma$ zugeordnet ist. Die Standardabweichung $\sigma$ ergibt sich nach der gauß'schen Verteilung als derjenige Wert, bei dem 95% aller Meßwerte innerhalb der Abweichung $\pm 2\sigma$ liegen. Die Dotierung, die dem Ausschnitt aus der Kapazitätskurve 10 zugrunde liegt, wurde mit einem 1 MHz- Oszillator erzeugt, welcher Frequenzteiler von 1 : 2000 und 1 : 810 enthält, mit phasenstarr gekoppelten Frequenzen von 500 Hz und 1234, 567 Hz.

Bild 3 zeigt, daß trotz eines Ionenstrahldurchmessers von weniger als 1 mm auf einer implantierten Siliciumscheibe eine Gleichmäßigkeit erzeugt wurde, die besser als 1% war.

Das angeführte Ausführungsbeispiel bezieht sich auf eine mittels des erfindungsgemäßen Verfahrens hergestellte Ionenimplantation von Halbleitersubstraten. Die Erfindung beschränkt sich jedoch nicht nur auf das Ausführungsbeispiel. Sie gilt vielmehr für die Ausleuchtung beliebiger Flächen mittels beliebiger Strahlen, für welche die Bedingungen nach Anspruch 1 und gegebenenfalls außerdem auch nach Anspruch 2 eingehalten wird. Es lassen sich hiermit mühelos Beispiele für die analoge Anwendung eines optischen Strahls oder eines ungeladenen Teilchenstrahls oder eines Elektronenstrahls finden.

Das erfindungsgemäße Verfahren ist zur Herstellung beliebiger Halbleiterbauelemente sowie integrierter
Schaltungen anwendbar.


3 Figuren
5 Patentansprüche

Patentansprüche

1. Verfahren zur Ausleuchtung von Flächen mittels eines Strahles von annähernd gauß'scher Verteilung bezüglich seiner Intensität von der Strahlmittelachse radial zum Rand hin, bei dem der Strahl relativ zu der auszuleuchtenden Fläche periodische Ablenkungen in zwei annähernd senkrecht zueinander verlaufenden Richtungen erfährt, die so beschaffen sind, daß die auszuleuchtende Fläche vom Strahl zeilenweise abgerastert wird, d a d u r c h g e k e n n z e i c h n e t, daß die periodischen Ablenkungen zwischen dem Strahl und der auszuleuchtenden Fläche so in einem festen Verhältnis zueinander stehen, daß das 1,5fache der Standardabweichung des Strahls größer ist als der Abstand zweier benachbarter Schreibspuren.

2. Verfahren nach Anspruch 1, d a d u r c h g e - k e n n z e i c h n e t, daß die Frequenzen der periodischen Ablenkungen des Strahls phasenstarr gekoppelt sind.

3. Verfahren nach Anspruch 1 und oder 2, d a d u r c h g e k e n n z e i c h n e t, daß der Strahl aus einem geladenen Teilchenstrahl besteht.

4. Verfahren nach Anspruch 3, d a d u r c h g e - k e n n z e i c h n e t, daß die periodische Strahlablenkung mittels zweier senkrecht zueinander gekreuzter Ablenkplattenpaare, an denen Abtastfrequenzen (Scanfrequenzen) anliegen, elektrisch abgelenkt wird.

5. Verfahren nach Anspruch 4, d a d u r c h   g e -
k e n n z e i c h n e t, daß der Strahl ein Ionenstrahl
ist, der von einem 1 MHz-Oszillator erzeugt wird und daß
die eine der beiden Abtastfrequenzen (Scanfrequenzen)
500 Hz und die andere Abtastfrequenz (Scanfrequenz)
1234, 567 Hz beträgt.

FIG 1

FIG 2

2/2

FIG 3

C[pF]

9.00
8.85
8.70
8.55
8.40
8.25
8.10
7.95
7.80
7.65
7.50

10 20 30 40 50   d [mm]

10

11

12

13

0027628

Europäisches
Patentamt

**EUROPÄISCHER RECHERCHENBERICHT**

Nummer der Anmeldung

EP 80 10 6236
-2-

| | **EINSCHLÄGIGE DOKUMENTE** | | KLASSIFIKATION DER ANMELDUNG (Int. Cl.³) |
|---|---|---|---|
| Kategorie | Kennzeichnung des Dokuments mit Angabe, soweit erforderlich, der Maßgeblichen Teile | betrifft Anspruch | |
| A | DE - A - 1 948 396 (HUGHES AIRCRAFT COMPANY)<br><br>* Seite 10, Zeilen 1-27 *<br><br>----- | 1,3,4 | |
| | | | **RECHERCHIERTE SACHGEBIETE (Int. Cl.³)** |

# EUROPÄISCHER RECHERCHENBERICHT

**0027628**

Nummer der Anmeldung

EP 80 10 6236

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | **US - A - 3 676 693** (COMMISSARIAT A L'ENERGIE ATOMIQUE) <br> * Spalte 1, Zeilen 21-28; Spalte 2, Zeilen 4-34; Figur 3 * <br><br> -- <br><br> SOLID STATE TECHNOLOGY, vol. 19. Juni 1976, Port Washington, Long Island, N.Y. (US) <br> J.L. STONE et al. "Recent advances in ion implantation - A state of the art review", <br> * Seite 42, linke Spalte, Zeilen 27-36, 39-43 und 48-51 * <br><br> -- | 1,3,4 <br><br><br><br><br> 1,3,4 |
| P | **GB - A - 2 020 896** (N.V. PHILIPS' GLOEILAMPENFABRIEKEN) <br> * Seite 1, Zeilen 22-35 und 49-71; Seite 4, Zeilen 75-79 und 93-118; Figuren 1,2 * <br><br> -- | 1,3,4 |
| A | PROCEEDINGS OF THE IEEE, vol. 62, September 1974, New York, N.Y. (US) <br> DON H. LEE et al. "Ion-implanted semiconductor devices" <br> * Seite 1243, rechte Spalte, Zeilen 23-35 * <br><br> -- | 1,3,4 |
| A | **DE - A - 2 547 674** (LICENTIA PATENT VERWALTUNGS GmbH) <br> * Seite 3, Zeilen 1-9; Seite 4, Zeilen 7 bis Seite 6, Zeile 1 * <br><br> -- <br><br> ./. | 1,3,4 |

### KLASSIFIKATION DER ANMELDUNG (Int. Cl.³)

G 21 K 5/04//
H 01 J 37/317
H 01 L 21/265

### RECHERCHIERTE SACHGEBIETE (Int. Cl.³)

G 21 K 5/04
H 01 J 37/147
37/28
37/302
37/317
3/28
3/30
H 01 L 21/26
21/265

### KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 23-01-1981 | HORAK |

EPA form 1503.1 06.78